# EUROPÄISCHE PATENTSCHRIFT

(11) **EP 0 799 913 B1**
(45) Veröffentlichungstag und Bekanntmachung des Hinweises auf die Patenterteilung: **03.07.2002**
(21) Anmeldenummer: 97101429.5
(22) Anmeldetag: 30.01.1997
(51) Int. Cl.: C30B 15/00

(54) **Vorrichtung zum Ziehen von Einkristallen**
Apparatus for pulling single crystals
Appareil pour le tirage de monocristaux

(30) Priorität: 03.04.1996 DE 19613282
(43) Veröffentlichungstag der Anmeldung: 08.10.1997
(73) Patentinhaber: Unaxis Deutschland Holding GmbH, 63450 Hanau (DE)
(72) Erfinder: Schulmann, Winfried, 63801 Kleinostheim (DE); Kaiser, Helmut, Dr., 63486 Bruchköbel (DE); Thimm, Franz, 63755 Alzenau (DE)
(74) Vertreter: Bockhorni, Josef, Dipl.-Ing.

(56) Entgegenhaltungen:
- EP-A- 0 460 477
- EP-A- 0 769 577
- DE-B- 1 290 117
- DE-U- 9 215 780
- US-A- 4 523 972

## Beschreibung

### Beschreibung für folgende Vertragsstaaten : GB, DE, IT

Die Erfindung betrifft eine Vorrichtung zum Ziehen von Einkristallen aus einer in einem Tiegel befindlichen Schmelze unter Vakuum oder unter Schutzgas bei vermindertem Druck, gemäß des Oberbegriffes des Patentanspruches 1.

Vorrichtungen zum Ziehen von Kristallen umfassen üblicherweise ein Gerüst oder Tragwerk aus Metallrohren oder Metallprofilen, an das die für den Ziehprozeß notwendigen Aggregate, wie z. B. die Vakuumkammer, die Schleuse, die Schleusenkammer, das Ziehelement, angebracht sind.

So ist eine Vorrichtung zum tiegellosen Zonenschmelzen bekannt (DE 1.290.117), bestehend aus zwei vertikalen Führungssäulen, die auf einem Podest befestigt und oben durch eine Querstrebe miteinander verbunden sind, welche zwei relativ zueinander und relativ zu einer ortsfesten Heizvorrichtung verschiebbare Arme mit den Stabhalterungen tragen, wobei die Arme mit einem Differentalgetriebe gekoppelt sind, und die beiden Führungssäulen mit zwei mittels Schraubgewinden oben an der Querstrebe und unten am Podest befestigten, schräg zu den Führungssäulen und zueinander verlaufenden Stützorganen ausgerüstet sind, wobei die Führungssäulen über je ein gleich hohes Biegegelenk in Gestalt eines nach der Seite der Stützorgane offenen Schlitzes mit dem Podest verbunden sind.

Diese bekannte Vorrichtung eignet sich nicht für Anlagen zum Ziehen sehr großer Kristalle, da die einzelnen Aggregate einer solchen großen Vorrichtung zu voluminös und zu schwer und für den Einbau in das bekannte Tragwerk zu wenig zugänglich für das Bedienpersonal sind.

Es ist auch ein Raumtragwerk mit zwei Bedienungsbühnen bekannt (GM 92 15 780.7), insbesondere für eine Vorrichtung zum Schmelzen, Gießen und/oder Verdüsen von Werkstoffen, mit mindestens einer evakuierbaren oder mit einem Verfahrensgas füllbaren Prozeßkammer, bei der die Grundflächen der beiden Bedienbühnen jeweils gleich große rechtwinklige Dreiecksflächen bilden, die in zwei waagerechten, zueinander parallelen Ebenen vorgesehen sind,
wobei die beiden Bedienbühnen von lotrecht angeordneten, sich auf der Stellfläche abstützenden Pfosten oder Ständern im Abstand zueinander gehalten sind, die jeweils an den die Bedienbühnen begrenzenden und einrahmenden, sich horizontal erstreckenden Trägern befestigt sind,
wobei zwei der Ständer jeweils an den äußeren Enden der Träger befestigt sind, die die Grundseiten der beiden als rechtwinklige, gleichschenklige Dreiecke ausgeformten Bedienbühnen bilden,
wobei ein weiteres Paar benachbarter Ständer in der jeweils mittleren Partie dieser beiden Träger vorgesehen und an ihnen fest angeordnet ist,
wobei ein drittes Paar von Ständern im Bereich der Verbindungsstellen der beiden Trägerpaare vorgesehen ist, die die Schenkel (Katheten) der als ebene Dreiecksflächen ausgeformten Bedienbühnen bilden,
wobei die beiden Bedienbühnen von einem Fachwerk von rasterartig angeordneten Streben durchzogen sind, die jeweils parallel zu den die Schenkel bildenden Trägerpaaren verlaufen,
wobei die von jeweils benachbarten Streben und/oder benachbarten Trägern gebildeten Fachwerköffnungen von Flurplatten, Rosten oder Grätings abgedeckt und lösbar mit diesen verbunden sind und
wobei durch eine oder mehrere Fachwerköffnungen eine Prozeßkammer und/oder Teile der Schmelz-, Gieß- oder Verdüsungsvorrichtung hindurchragen, die auf der Stellfläche abgestützt oder von Streben gehalten ist.

Dieses bekannte Raumtragwerk eignet sich kaum für eine besonders schmale und dabei extrem hohe Vorrichtung, wie sie für das Kristallziehen Verwendung findet, da einerseits die vom Raumtragwerk beanspruchte Grundfläche unverhältnismäßig groß ist und andererseits sich keine Möglichkeiten bieten, Schwenkarme zum horizontalen Verfahren von schweren Maschinenteilen zu lagern.

In der EP-A-0 769 577 ist außerdem eine gattungsgemäße Vorrichtung nachveröffentlicht und vorgeschlagen, bei der wenigstens drei Beine eines vierbeinigen Grundgestells nach oben über eine Plattform verlängert sind, um an einem dieser verlängerten Beine einen Schwenkarm für die Schleusenkammer zur besseren Entnahme des Einkristalles zu lagern.

Der vorliegenden Erfindung liegt die Aufgabe zugrunde, eine Vorrichtung der infragestehenden Art zu schaffen, die frei ist von den Nachteilen der bekannten Vorrichtungen und die bei höchster Steifigkeit, preiswert herstellbar ist, die allerbeste Zugänglichkeit aller Aggregate ermöglicht und insbesondere ein problemloses Entnehmen des fertigen Kristalls ermöglicht.

Diese Aufgabe wird erfindungsgemäß durch die kennzeichnenden Merkmale des Patentanspruches 1 gelöst.

Weitere Einzelheiten und Merkmale sind in den Unteransprüchen näher beschrieben und gekennzeichnet.

Die Erfindung läßt die verschiedensten Ausführungsmöglichkeiten zu; zwei davon sind in den anhängenden Zeichnungen schematisch näher dargestellt und zwar zeigen:
- Fig. 1: eine erfindungsgemäße Vorrichtung in perspektivischer Darstellung mit am Gestell gehaltenen Aggregaten und Handlingssystemen und
- Fig. 2: eine Vorrichtung ähnlich der nach Fig. 1, jedoch in zwei Seitenansichten, die gegeneinander um 135° verdreht gezeichnet sind.

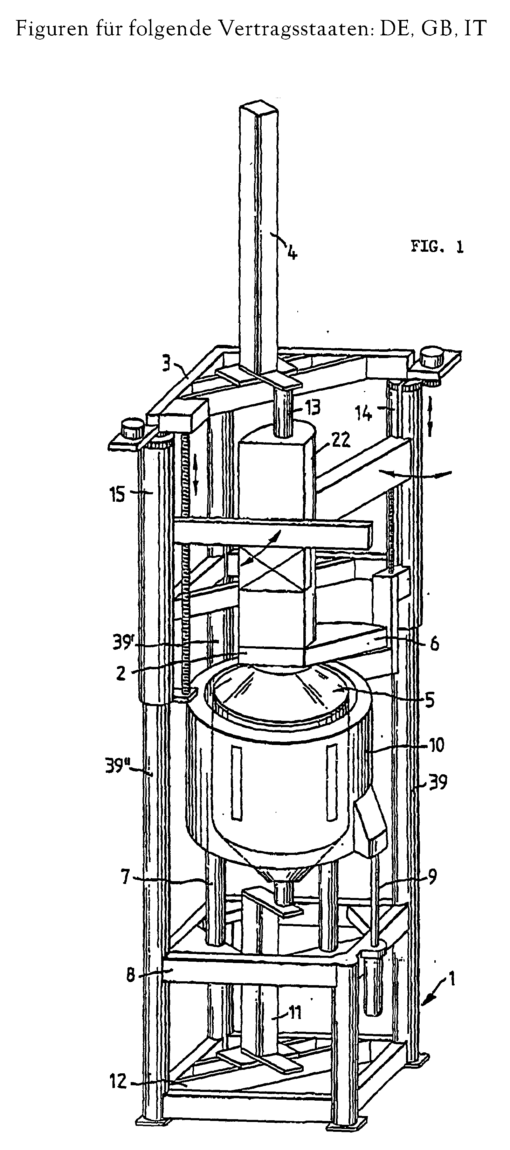

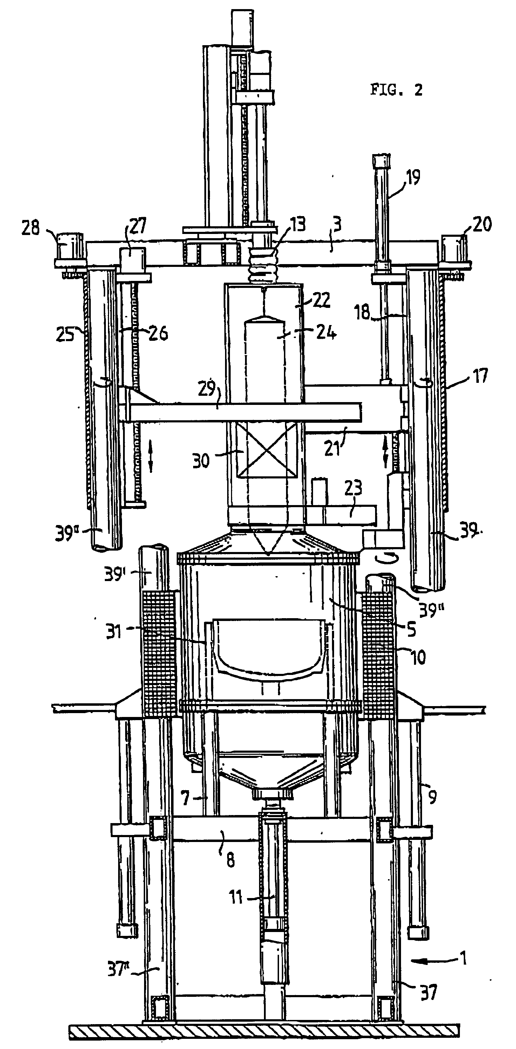

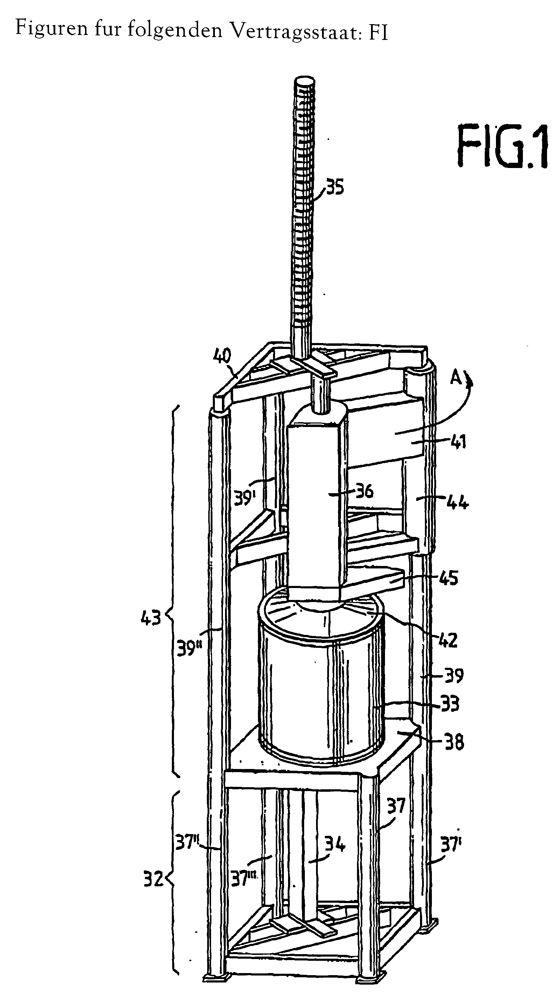

Bei dem Ausführungsbeispiel gemäß Fig. 1 ist auf ein vierbeiniges, als Gitterrohrrahmen ausgeführtes Grundgestell 1, von dem aus drei Säulen über die Schleuse 2 nach oben zu hinaufreichen, ein dreieckiger Abschlußrahmen 3 aufgeschraubt. Auf diesen Rahmen ist der Ziehvorschub 4 (Stangenvorschub oder Seilvorschub) aufgesetzt. Die Kesselteile 5 sowie das Schleusenventil 6 und die Schleuse 2 sind mittels Stützen 7 auf Querverbindungen 8 des Grundgestells 1 gelagert. Ebenfalls stützt sich der Magnet 10 oder dessen Hebe- und Senkeinrichtung 9 auf Querverbindungen 8 ab. Die Querverbindungen 8 sind dergestalt ausgeführt und angeordnet, daß der Magnet 10 zu Wartungs- oder Reinigungszwekken der Anlage abgesenkt werden kann. Der Tiegelvorschub 11 stützt sich auf den unteren Querverbindungen 12 des Grundgestells 1 ab. Kesselteile 5, Schleusenventil 6 und Schleuse 2 sind mittels Balg 13 von den Vorschüben 4 und 11 schwingungstechnisch und lagemäßig entkoppelt, so daß kein nachteiliger Einfluß durch auftretende Schwingungen oder Lageveränderung der Kesselteile 5, 6, 2 auf den Ziehvorgang auftritt.

In die nach oben verlängerten Säulen 39, 39', 39" des Grundgestells 1 können nun unterschiedliche Funktionselemente integriert werden, z. B. eine speziell ausgeführte Handlingseinrichtung 14 für die Schleuse 2 und das Schleusenventil 6 oder für Kesselteile 5 sowie für den Trennmechanismus für den Kristallhals, für Aufnahmeeinrichtungen für Kristalle, Handlingseinrichtungen 15 für Kesselteile und/oder Hot-Zoneteile 16 innerhalb der Kessel 5. Ebenfalls integrierbar sind Zusatzeinrichtungen wie Chargiereinrichtung und Dotiereinrichtung.

Das Grundgestell eignet sich auch für den Einbau von Zwischenpodesten zu Reinigungs- und Wartungszwecken.

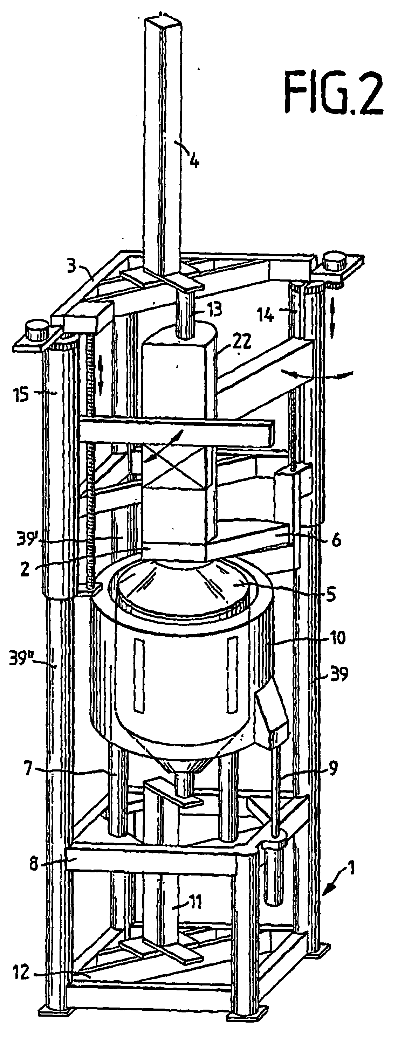

Beim Ausführungsbeispiel gemäß Fig. 2 ist eine Handlingseinrichtung in der rechten, hinteren Säule des Grundgestells 1 integriert, bestehend aus dem Schwenklager 17, der Linearführung 18, der Hubeinheit 19, der Schwenkeinheit 20 und dem Galgen 21, der zum Heben und/oder Schwenken der Schleuse 22 und/oder des Schleusenventils 23 in eine gut zugängliche Position zu Wartungsoder Reinigungszwecken und/oder zur Kristallentnahme 24 aus der Schleuse 22 dient.

Durch Betätigen der Hubeinheit 19 wird die Schleuse 22 und/oder das Schleusenventil 23 angehoben. Durch Betätigen der Schwenkeinheit 20 können die Schleuse 22 bzw. das Schleusenventil 23 von den Kesselteilen weggeschwenkt und in eine gut zugängliche Position gebracht werden.

Eine Handlingsgrundeinheit besteht aus einem Schwenklager 28 sowie einem Galgen 29. Sie dient zur Aufnahme von Handlingsmodulen 30 für Hot-Zoneteilen, Kesselteilen, Magneten und/oder der Kristallentnahme.

Das entsprechende Handlingsmodul 30 (z. B. für Hot-Zoneteile) wird in den Galgen 13 eingehängt. Dieser wird mittels Hubeinheit 27 und der Schwenkeinheit 28 in die vorgesehene Entnahmeposition gefahren. Das Handlingsmodul 30 nimmt die vorgesehene Komponente 31 auf. Dann wird die Komponente 31 mittels 27 und 28 aus dem Kessel entnommen und in eine günstige, gut zugängliche Position geschwenkt und abgesetzt.

### Beschreibung für folgenden Vertragsstaat : FI

Die Erfindung betrifft eine Vorrichtung zum Ziehen von Einkristallen aus einer in einem Tiegel befindlichen Schmelze unter Vakuum oder unter Schutzgas bei vermindertem Druck, wobei der Tiegel in einer auf einem Grundgestell abgestützten Vakuumkammer auf einem Tiegeltragbolzen angeordnet und durch die Wärmestrahlung eines Heizelements erhitzbar ist, und wobei ein Ziehelement oberhalb der Schmelze vorgesehen ist, mit der der Kristall von der Schmelzenoberfläche aus nach oben zu in eine gegenüber dem Grundgestell seitlich schwenkbare Schleusenkammer herausziehbar ist sowie mit einer Entkopplungsvorrichtung, die zwischen dem Kristall und dem Ziehelement vorgesehen ist und die Trennung des Kristalls von dem Ziehelement gestattet.

Vorrichtungen zum Ziehen von Kristallen umfassen üblicherweise ein Gerüst oder Tragwerk aus Metallrohren oder Metallprofilen, an das die für den Ziehprozeß notwendigen Aggregate, wie z. B. die Vakuumkammer, die Schleuse, die Schleusenkammer, das Ziehelement, angebracht sind.

So ist eine Vorrichtung zum tiegellosen Zonenschmelzen bekannt (DE 1.290.117), bestehend aus zwei vertikalen Führungssäulen, die auf einem Podest befestigt und oben durch eine Querstrebe miteinander verbunden sind, welche zwei relativ zueinander und relativ zu einer ortsfesten Heizvorrichtung verschiebbare Arme mit den Stabhalterungen tragen, wobei die Arme mit einem Differentalgetriebe gekoppelt sind, und die beiden Führungssäulen mit zwei mittels Schraubgewinden oben an der Querstrebe und unten am Podest befestigten, schräg zu den Führungssäulen und zueinander verlaufenden Stützorganen ausgerüstet sind, wobei die Führungssäulen über je ein gleich hohes Biegegelenk in Gestalt eines nach der Seite der Stützorgane offenen Schlitzes mit dem Podest verbunden sind.

Diese bekannte Vorrichtung eignet sich nicht für Anlagen zum Ziehen sehr großer Kristalle, da die einzelnen Aggregate einer solchen großen Vorrichtung zu voluminös und zu schwer und für den Einbau in das bekannte Tragwerk zu wenig zugänglich für das Bedienpersonal sind.

Es ist auch ein Raumtragwerk mit zwei Bedienungsbühnen bekannt (GM 92 15 780.7), insbesondere für eine Vorrichtung zum Schmelzen, Gießen und/oder Verdüsen von Werkstoffen, mit mindestens einer evakuierbaren oder mit einem Verfahrensgas füllbaren Prozeßkammer, bei der die Grundflächen der beiden Bedienbühnen jeweils gleich große rechtwinklige Dreiecksflächen bilden, die in zwei waagerechten, zueinander parallelen Ebenen vorgesehen sind,
wobei die beiden Bedienbühnen von lotrecht angeordneten, sich auf der Stellfläche abstützenden Pfosten oder Ständern im Abstand zueinander gehalten sind, die jeweils an den die Bedienbühnen begrenzenden und einrahmenden, sich horizontal erstreckenden Trägern befestigt sind,
wobei zwei der Ständer jeweils an den äußeren Enden der Träger befestigt sind, die die Grundseiten der beiden als rechtwinklige, gleichschenklige Dreiecke ausgeformten Bedienbühnen bilden,
wobei ein weiteres Paar benachbarter Ständer in der jeweils mittleren Partie dieser beiden Träger vorgesehen und an ihnen fest angeordnet ist,
wobei ein drittes Paar von Ständern im Bereich der Verbindungsstellen der beiden Trägerpaare vorgesehen ist, die die Schenkel (Katheten) der als ebene Dreiecksflächen ausgeformten Bedienbühnen bilden,
wobei die beiden Bedienbühnen von einem Fachwerk von rasterartig angeordneten Streben durchzogen sind, die jeweils parallel zu den die Schenkel bildenden Trägerpaaren verlaufen,
wobei die von jeweils benachbarten Streben und/oder benachbarten Trägern gebildeten Fachwerköffnungen von Flurplatten, Rosten oder Grätings abgedeckt und lösbar mit diesen verbunden sind und
wobei durch eine oder mehrere Fachwerköffnungen eine Prozeßkammer und/oder Teile der Schmelz-, Gieß- oder Verdüsungsvorrichtung hindurchragen, die auf der Stellfläche abgestützt oder von Streben gehalten ist.

Dieses bekannte Raumtragwerk eignet sich kaum für eine besonders schmale und dabei extrem hohe Vorrichtung, wie sie für das Kristallziehen Verwendung findet, da einerseits die vom Raumtragwerk beanspruchte Grundfläche unverhältnismäßig groß ist und andererseits sich keine Möglichkeiten bieten, Schwenkarme zum horizontalen Verfahren von schweren Maschinenteilen zu lagern.

Der vorliegenden Erfindung liegt die Aufgabe zugrunde, eine Vorrichtung der infragestehenden Art zu schaffen, die frei ist von den Nachteilen der bekannten Vorrichtungen und die bei höchster Steifigkeit, preiswert herstellbar ist, die allerbeste Zugänglichkeit aller Aggregate ermöglicht und insbesondere ein problemloses Entnehmen des fertigen Kristalls ermöglicht.

Diese Aufgabe wird erfindungsgemäß dadurch gelöst, daß das Grundgestell aus einer von Stützen getragenen Plattform gebildet ist, wobei auf der etwa rechteckigen, die Vakuumkammer haltenden Plattform an drei ihrer vier Ecken jeweils ein weiteres Bein abgestützt ist und diese drei sich lotrecht erstreckenden Beine gleicher Länge zusammen an ihren oberen Enden von einem ein rechteckiges Dreieck bildenden, sich horizontal erstreckenden Rahmen gehalten sind, wobei die von diesem Rahmen auf die Plattform projizierte Fläche etwa die eine Hälfte der Plattformfläche umschreibt, und wobei mindestens an einem der Beine ein Galgen oder Schwenkarm gelagert ist , an dem die Schleusenkammer befestigt ist, die sich parallel der Beine bis etwa zum Deckel der Vakuumkammer erstreckt.

Weitere Einzelheiten und Merkmale sind in den Unteransprüchen näher beschrieben und gekennzeichnet.

Die Erfindung läßt die verschiedensten Ausführungsmöglichkeiten zu; zwei davon sind in den anhängenden Zeichnungen schematisch näher dargestellt und zwar zeigen:
- Fig. 1: eine Vorrichtung nach der Erfindung mit einem vierbeinigen Unter- und einem dreibeinigen Obergestell in perspektivischer Darstellung,
- Fig. 2: eine ähnliche Vorrichtung in perspektivischer Darstellung, jedoch mit weiteren am Gestell gehaltenen Aggregaten und Handlingssystemen und

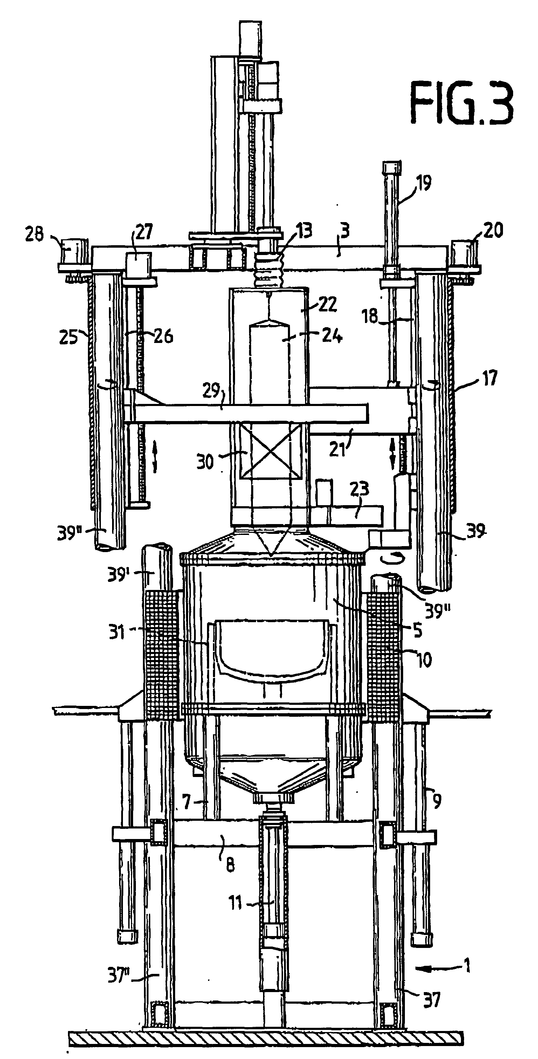

- Fig. 3: eine Vorrichtung ähnlich der nach Fig. 2, jedoch in zwei Seitenansichten, die gegeneinander um 135 ° verdreht gezeichnet sind.

Die Vorrichtung gemäß Fig. 1 besteht im wesentlichen aus einem Grundgestell 32 mit insgesamt vier lotrechten Stützen 37, die an den Ecken einer etwa quadratischen Plattform 38 angeordnet sind, einer auf der Plattform 38 gehaltenen Vakuumkammer 33 mit Deckel 42, aus einem Obergestell 43, bestehend aus insgesamt drei Beinen, 39, 39', 39", die zweckmäßigerweise als verlängerte Stützen 37', 37", 37"' ausgebildet sind und durch einen ein rechtwinkliges Dreieck bildenden Rahmen 40 zusammengehalten sind, einen auf dem Rahmen 40 abgestützten Ziehelement 35 und einer von einem Schwenkarm 41 gehaltenen Schleusenkammer 36, wobei der Schwenkarm 41 an einem auf dem Bein 39 gelagerten Schenklager 44 befestigt ist. In der Vakuumkammer 33 befindet sich der Tiegel mit der Schmelze aus der der Kristall durch die Schleuse 45 in den die Schleusenkammer 36 gezogen wird, und zwar mit Hilfe des Ziehelements 35. Nach beendetem Ziehvorgang wird das Ziehelement 35 von dem in der Schleusenkammer 36 hängenden Kristall abgekoppelt und die Schleuse 45 wird geschlossen. Nach dem Schließen der Schleuse 45 kann die Schleusenkammer 36 in Pfeilrichtung A verschwenkt werden und zwar soweit, daß der Kristall aus der Schleusenkammer entnommen und nach unten zu seitlich an der Vakuumkammer 33 vorbei abtransportiert werden kann.

Bei dem Ausführungsbeispiel gemäß Fig. 2 ist auf ein vierbeiniges, als Gitterrohrrahmen ausgeführtes Grundgestell 1, von dem aus drei Säulen über die Schleuse 2 nach oben zu hinaufreichen, ein dreieckiger Abschlußrahmen 3 aufgeschraubt. Auf diesen Rahmen ist der Ziehvorschub 4 (Stangenvorschub oder Seilvorschub) aufgesetzt. Die Kesselteile 5 sowie das Schleusenventil 6 und die Schleuse 2 sind mittels Stützen 7 auf Querverbindungen 8 des Grundgestells 1 gelagert. Ebenfalls stützt sich der Magnet 10 oder dessen Hebeund Senkeinrichtung 9 auf Querverbindungen 8 ab. Die Querverbindungen 8 sind dergestalt ausgeführt und angeordnet, daß der Magnet 10 zu Wartungsoder Reinigungszwecken der Anlage abgesenkt werden kann. Der Tiegelvorschub 11 stützt sich auf den unteren Querverbindungen 12 des Grundgestells 1 ab. Kesselteile 5, Schleusenventil 6 und Schleuse 2 sind mittels Balg 13 von den Vorschüben 4 und 11 schwingungstechnisch und lagemäßig entkoppelt, so daß kein nachteiliger Einfluß durch auftretende Schwingungen oder Lageveränderung der Kesselteile 5, 6, 2 auf den Ziehvorgang auftritt.

In die nach oben verlängerten Säulen 39, 39', 39" des Grundgestells 1 können nun unterschiedliche Funktionselemente integriert werden, z. B. eine speziell ausgeführte Handlingseinrichtung 14 für die Schleuse 2 und das Schleusenventil 6 oder für Kesselteile 5 sowie für den Trennmechanismus für den Kristallhals, für Aufnahmeeinrichtungen für Kristalle, Handlingseinrichtungen 15 für Kesselteile und/oder Hot-Zoneteile 16 innerhalb der Kessel 5. Ebenfalls integrierbar sind Zusatzeinrichtungen wie Chargiereinrichtung und Dotiereinrichtung.

Das Grundgestell eignet sich auch für den Einbau von Zwischenpodesten zu Reinigungs- und Wartungszwecken.

Beim Ausführungsbeispiel gemäß Fig. 3 ist eine Handlingseinrichutng in der rechten, hinteren Säule des Grundgestells 1 integriert, bestehend aus dem Schwenklager 17, der Linearführung 18, der Hubeinheit 19, der Schwenkeinheit 20 und dem Galgen 21, der zum Heben und/oder Schwenken der Schleuse 22 und/oder des Schleusenventils 23 in eine gut zugängliche Position zu Wartungs- oder Reinigungszwecken und/oder zur Kristallentnahme 24 aus der Schleuse 22 dient.

Durch Betätigen der Hubeinheit 19 wird die Schleuse 22 und/oder das Schleusenventil 23 angehoben. Durch Betätigen der Schwenkeinheit 20 können die Schleuse 22 bzw. das Schleusenventil 23 von den Kesselteilen weggeschwenkt und in eine gut zugängliche Position gebracht werden.

Eine Handlingsgrundeinheit besteht aus einem Schwenklager 28 sowie einem Galgen 29. Sie dient zur Aufnahme von Handlingsmodulen 30 für Hot-Zoneteilen, Kesselteilen, Magneten und/oder der Kristallentnahme.

Das entsprechende Handlingsmodul 30 (z. B. für Hot-Zoneteile) wird in den Galgen 13 eingehängt. Dieser wird mittels Hubeinheit 27 und der Schwenkeinheit 28 in die vorgesehene Entnahmeposition gefahren. Das Handlingsmodul 30 nimmt die vorgesehene Komponente 31 auf. Dann wird die Komponente 31 mittels 27 und 28 aus dem Kessel entnommen und in eine günstige, gut zugängliche Position geschwenkt und abgesetzt.

### Bezugszeichenliste

- 1: Gestell
- 2: Schleuse
- 3: Abschlußrahmen
- 4: Ziehvorschub
- 5: Kesselteile, Vakuumkammer
- 6: Schleusenventil
- 7: Stütze
- 8: Querverbindung
- 9: Hebe-/Senkeinrichtung
- 10: Magnet
- 11: Tiegelvorschub
- 12: Querverbindung
- 13: Balg
- 14: Handlingseinrichtung
- 15: Handlingseinrichtung
- 16: Kesselteil, Hot-Zonenteil
- 17: Schwenklager
- 18: Linearführung
- 19: Hubeinheit
- 20: Schwenkeinheit
- 21: Galgen
- 22: Schleuse, Schleusenkammer
- 23: Schleusenventil
- 24: Kristallentnahme
- 25: Schwenklager
- 26: Linearführung
- 27: Hubeinheit
- 28: Schwenkeinheit
- 29: Galgen
- 30: Handlingsmodul
- 31: Komponente
- 32: Grundgestell
- 33: Vakuumkammer
- 34: Tiegeltragbolzen
- 35: Ziehelement
- 36: Schleusenkammer
- 37, 37', ...: Stütze
- 38: Plattform
- 39, 39', ...: Bein
- 40: Rahmen
- 41: Galgen, Schwenkarm
- 42: Deckel
- 43: Obergestell
- 44: Schwenklager
- 45: Schleuse

## Patentansprüche (Patentansprüche für folgende(n) Vertragsstaat(en): DE, GB, IT)

1. Vorrichtung zum Ziehen von Einkristallen aus einer in einem Tiegel befindlichen Schmelze unter Vakuum oder unter Schutzgas bei vermindertem Druck, wobei der Tiegel in einer auf einem Grundgestell (1); abgestützten Vakuumkammer (5) auf einem Tiegeltragbolzen (11) abgeordnet und durch die Wärmestrahlung eines Heizelements erhitzbar ist, und wobei ein Ziehelement (4), oberhalb der Schmelze vorgesehen ist, mit dem der Kristall von der Schmelzenoberfläche aus nach oben zu in eine gegenüber dem Grundgestell (1) seitlich schwenkbare Schleusenkammer (22) herausziehbar ist, sowie mit einer Entkopplugsvorrichtung, die zwischen dem Kristall und dem Ziehelement (4) vorgesehen ist und die Trennung des Kristalls von dem Ziehelement (4) gestattet, wobei das Grundgestell (1) aus einer von Stützen (37, 37', 37", 37''') getragenen Plattform (Querverbindungen 8) gebildet ist, wobei auf der etwa rechteckigen, die Vakuumkammer (5) haltenden Plattform an drei ihrer vier E-cken jeweils ein weiteres Bein (39, 39', 39") abgestützt ist und diese drei sich lotrecht erstreckenden Beine (39,39', 39") gleicher Länge zusammen an ihren oberen Enden von einem ein rechteckiges Dreieck bildenden, sich horizontal erstreckenden Rahmen (3) gehalten sind, wobei die von diesem Rahmen (3) auf die Plattform projizierte Fläche etwa die eine Hälfte der Plattformfläche umschreibt, wobei an mindestens einem der Beine (39,39', 39") ein Galgen oder Schenkarm (21) gelagert ist, an dem die Schleusenkammer (22) befestigt ist, die sich parallel der Beine (39, 39', 39'') bis etwa zum Deckel der Vakuumkammer (5) erstreckt, und wobei zumindest eines der Beine (39, 39', 39") die Welle eines vertikalen Schwenklagers (44) bildet, an dem ein sich horizontal erstreckender Am (21) gefestigt ist, der seinerseits die Schleusenkammer (5) trägt, **dadurch gekennzeichnet, dass** in ein weiteres der Beine (39, 39', 39") Funktionselemente einer Handlingseinrichtung (15) und/oder einer sonstigen Zusatzeinrichtung, insbesondere für Kesselteile und/oder Hot-Zoneteile, integriert sind.

2. Vorrichtung nach Anspruch 1, **dadurch gekennzeichnet, dass** die Handlingseinheit (15) aus einem Schwenklager (28) sowie einem Galgen (29) besteht.

3. Vorrichtung nach Anspruch 1 oder 2, **dadurch gekennzeichnet, dass** die Handlingsbzw. Zusatzeinrichtung als Schwenk- und Hub-Einrichtung (27, 28) ausgebildet ist.

4. Vorrichtung nach einem der vorhergehenden Ansprüche, **dadurch gekennzeichnet, dass** an einer der Querverbindungen (8) eine Hebe/Senkeinrichtung (9) abgestützt ist, über die ein die Vakuumkammer (5) umschließender Ringmagnet (10) vertikal bewegbar ist.

5. Vorrichtung nach einem oder mehreren der vorhergehenden Ansprüche, **dadurch gekennzeichnet, dass** der Kessel bzw. die Vakuumkammer (5) auf der Plattform bzw. den Querverbindungen (8) abgestützt ist

## Patentansprüche (Patentansprüche für folgende(n) Vertragsstaat(en): FI)

1. Vorrichtung zum Ziehen von Einkristallen aus einer in einem Tiegel befindlichen Schmelze unter Vakuum oder unter Schutzgas bei vermindertem Druck, wobei der Tiegel in einer auf einem Grundgestell (1, 32) abgestützten Vakuumkammer (5, 33) auf einem Tiegeltragbolzen (11, 34) angeordnet und durch die Wärmestrahlung eines Heizelements erhitzbar ist, und wobei ein Ziehelement (4, 35) oberhalb der Schmelze vorgesehen ist, mit dem der Kristall von der Schmelzenoberfläche aus nach oben zu in eine gegenüber dem Grundgestell (1, 32) seitlich schwenkbare Schleusenkammer (22, 36) herausziehbar ist sowie mit einer Entkopplungsvorrichtung, die zwischen dem Kristall und dem Ziehelement (4, 35) vorgesehen ist und die Trennung des Kristalls von dem Ziehelement (4, 35) gestattet, **dadurch gekennzeichnet, daß** das Grundgestell (1, 32) aus einer von Stützen (37, 37', 37", 37"') getragenen Plattform (8, 38) gebildet ist, wobei auf der etwa rechteckigen, die Vakuumkammer (5, 33) haltenden Plattform (8, 38) an drei ihrer vier Ecken jeweils ein weiteres Bein (39, 39', 39") abgestützt ist und diese drei sich lotrecht erstreckenden Beine (39, 39', 39") gleicher Länge zusammen an ihren oberen Enden von einem ein rechteckiges Dreieck bildenden, sich horizontal erstreckenden Rahmen (3, 40) gehalten sind, wobei die von diesem Rahmen (3, 40) auf die Plattform (8, 38) projizierte Fläche etwa die eine Hälfte der Plattformfläche umschreibt, wobei an mindestens einem der Beine (39, 39', 39") ein Galgen oder Schwenkarm (21, 29 41) gelagert ist, an dem die Schleusenkammer (22, 36) befestigt ist, die sich parallel der Beine (39, 39', 39") bis etwa zum Deckel (42) der Vakuumkammer (5, 33) erstreckt.

2. Vorrichtung nach Anspruch 1, **dadurch gekennzeichnet, daß** drei Stützen (37', 37", 37" ') des Grundgestells (32) über die Plattform (38) hinaus verlängert sind und die drei Beine (39, 39', 39") des Obergestells (43) bilden.

3. Vorrichtung nach den Ansprüchen 1 und 2, **dadurch gekennzeichnet, daß** zumindest eines der Beine (39) die Welle eines vertikalen Schwenklagers (44) bildet, an dem ein sich horizontal erstreckender Arm (41) befestigt ist, der seinerseits die Schleusenkammer (36) trägt.

4. Vorrichtung nach den Ansprüchen 1 bis 3, **dadurch gekennzeichnet, daß** an der Plattform (38) oder Querverbindung (8) eine Hebe/Senkeinrichtung (9) abgestützt ist, über die ein die Vakuumkammer (5) umschließender Ringmagnet (10) vertikal bewegbar ist.

5. Vorrichtung nach einem oder mehreren der vorhergehenden Ansprüche, **dadurch gekennzeichnet, daß** der Kessel bzw. die Vakuumkammer (5, 33) auf der Plattform (38) oder der Querverbindung (8) abgestützt ist.

## Claims (Claims for the following Contracting State(s): DE, GB, IT)

1. Apparatus for drawing single crystals from a fused mass situated in a crucible under vacuum or under a protective gas at reduced pressure, wherein the crucible is disposed in a vacuum chamber (5), supported on a base frame (1), on a crucible support post (11) and may be heated by the thermal radiation from a heating element, and wherein a drawing element (4) is provided above the fused mass, with which the crystal may be drawn out upwardly from the surface of the fused mass into a lock chamber (22), which is laterally pivotable with respect to the base frame (1), and including a decoupling device, which is provided between the crystal and the drawing element (4, 35) and permits the separation of the crystal from the drawing element (4), the base frame (1) being constituted by a platform (transverse connections (8)) supported by columns (37, 37', 37", 37'''), whereby bearing on the approximately rectangular platform, which holds the vacuum chamber (5), on three of its four corners, there is a respective further leg (39, 39', 39") and these three vertically extending legs (39, 39', 39") of the same length are held together at their upper ends by a frame (3), which defines a right-angled triangle and extends horizontally, the area projected by this frame (3) onto the platform circumscribing about one half of the area of the platform, a girder or pivot arm (21) being mounted on at least one of the legs (39, 39', 39"), to which the lock chamber (22) is secured, which extends parallel to the legs (39, 39', 39") to about the cover (42) of the vacuum chamber (5), whereby at least one of the legs (39, 39', 39") constitutes the shaft of a vertical pivotal bearing (44), secured to which is a horizontally extending arm (41), which, for its part, carries the lock chamber (5). **characterised in that** functional elements of a handling device (15) and/or some other additional device, particularly for tank components and/or hot zone components, are integrated in a further one of the legs (39, 39', 39").

2. Apparatus as claimed in Claim 1, **characterised in that** the handling unit (15) comprises the pivotal bearing (28) and a girder (29).

3. Apparatus as claimed in Claim 1 or 2, **characterised in that** the handling or additional device is constructed in the form of a pivoting and lifting device (27, 28).

4. Apparatus as claimed in one of the preceding claims, **characterised in that** supported on one of the transverse connections (8) there is a lifting/lowering device (9), by means of which an annular magnet (10) extending around the vacuum chamber (5) is vertically movable.

5. Apparatus as claimed in one or more of the preceding claims, **characterised in that** the tank or the vacuum chamber (5) is supported on the platform or the transverse connections.

## Claims (Claims for the following Contracting State(s): FI)

1. Apparatus for drawing single crystals from a fused mass situated in a crucible under vacuum or under a protective gas at reduced pressure, wherein the crucible is disposed in a vacuum chamber (5, 33), supported on a base frame (1, 32), on a crucible support post (11, 34) and may be heated by the thermal radiation from a heating element, and wherein a drawing element (4, 35) is provided above the fused mass, with which the crystal may be drawn out upwardly from the surface of the fused mass into a lock chamber (22, 36), which is laterally pivotable with respect to the base frame (1, 32), and including a decoupling device, which is provided between the crystal and the drawing element (4, 35) and permits the separation of the crystal from the drawing element (4, 35), **characterised in that** the base frame (1, 32) is constituted by a platform (8, 38) supported by columns (37, 37', 37", 37'''), whereby bearing on the approximately rectangular platform (8, 38), which holds the vacuum chamber (5, 33), on three of its four corners, there is a respective further leg (39, 39', 39") and these three vertically extending legs (39, 39', 39") of the same length are held together at their upper ends by a frame (3, 40), which defines a right-angled triangle and extends horizontally, whereby the area projected by this frame (3, 40) onto the platform (8, 38) circumscribes about one half of the area of the platform, a girder or pivot arm (21, 29, 41) being mounted on at least one of the legs (39, 39', 39"), to which the lock chamber (22, 36) is secured, which extends parallel to the legs (39, 39', 39") to about the cover (42) of the vacuum chamber (5, 33).

2. Apparatus as claimed in Claim 1, **characterised in that** three columns (37', 37", 37"') of the base frame (32) are extended beyond the platform (38) and constitute the three legs (39, 39', 39") of the upper frame (43).

3. Apparatus as claimed in Claims 1 and 2, **characterised in that** at least one of the legs (39) constitutes the shaft of a vertical pivotal bearing (44), secured to which is a horizontally extending arm (41), which, for its part, carries the lock chamber (36).

4. Apparatus as claimed in Claims 1 to 3, **characterised in that** supported on the platform (38) or transverse connection (8) there is a lifting/lowering device (9), by means of which a ring magnet (10) surrounding the vacuum chamber (5) is vertically movable.

5. Apparatus as claimed in one or more of the preceding claims, **characterised in that** the tank or the vacuum chamber (5, 33) is supported on the platform (38) or the transverse connection (8).

## Revendications (Revendications pour l'(les) Etat(s) contractant(s) suivant(s): DE, GB, IT)

1. Dispositif pour le tirage de monocristaux à partir d'un bain de fusion se trouvant dans un creuset, sous vide et sous gaz protecteur à pression réduite, le creuset étant disposé dans une chambre de vide (5) supportée un bâti (1) sur un pied porteur de creuset (11) et pouvant être chauffé par le rayonnement thermique d'un élément de chauffage, et un élément de tirage (4) étant prévu au-dessus du bain de fusion, élément de tirage avec lequel le cristal peut être prélevé de la surface de fusion vers le haut jusque dans un sas (22) basculant latéralement par rapport au bâti (1) ainsi qu'avec un dispositif de désaccouplement qui est prévu entre le cristal et l'élément de tirage (4) et permet la séparation du cristal de l'élément de tirage (4), le bâti (1) étant formé par une plate-forme (liaisons transversales (8) portée par des appuis (37,37',37",37"'), sur la plate-forme (5) sensiblement rectangulaire maintenant la chambre de vide (5) une autre jambe (39,39',39") étant respectivement supportée sur trois de ses quatre coins et ces trois jambes (39,39',39") de même longueur s'étendant verticalement étant maintenues par un châssis (3) s'étendant horizontalement, formant un triangle rectangle sur leurs extrémités supérieures, la surface projetée par ce châssis (3) sur la plate-forme circonscrivant sensiblement la moitié de la surface de la plate-forme, au moins l'une des jambes (39,39',39") portant une potence ou bras pivotant (21) sur lequel est fixé le sas (22) qui s'étend parallèlement aux jambes (39,39',39") jusqu'à sensiblement le couvercle de la chambre de vide (5), et au moins l'une des jambes (39,39',39") formant l'arbre d'un palier pivotant (44), sur lequel est fixé un bras (21) s'étendant horizontalement, qui porte pour sa part porte le sas (5), **CARACTERISE EN CE QUE** dans une autre des jambes (39,39',39") sont intégrés des éléments de fonction d'un système de manipulation (15) et/ou d'un autre système supplémentaire, en particulier pour des éléments de chaudière et/ou parties de zones haute température.

2. Dispositif selon la revendication 1, **CARACTERISE EN CE QUE**, l'unité de manipulation (15) consiste en un palier pivotant (28) ainsi qu'en une potence (29).

3. Dispositif selon la revendication 1 ou 2, **CARACTERISE EN CE QUE**, le système de manipulation ou système supplémentaire est conçu comme système de basculement et de levage (27,28).

4. Dispositif selon l'une des revendications précédentes, **CARACTERISE EN CE QU'**un système de levage et de descente (9) est supporté sur l'une des liaisons transversales (8), par lequel un aimant annulaire (10) entourant la chambre de vide (5) est mobile verticalement.

5. Dispositif selon une ou plusieurs des revendications précédentes, **CARACTERISE EN CE QUE** la chaudière ou la chambre de vide (5) sont soutenues par la plate-forme ou les liaisons transversales (8).

## Revendications (Revendications pour l'(les) Etat(s) contractant(s) suivant(s): FI)

1. Dispositif pour le tirage de monocristaux à partir d'un bain de fusion se trouvant dans un creuset, sous vide ou sous gaz protecteur à pression réduite, le creuset étant disposé dans une chambre de vide (5, 33) supportée par un bâti (1,32) sur un pied porteur de creuset (11,34) et pouvant être chauffé par le rayonnement thermique d'un élément de chauffage, et un élément de tirage (4,35) étant prévu au-dessus du bain de fusion, avec lequel le cristal peut être prélevé de le surface de fusion vers le haut jusque dans un sas (22,36) basculant latéralement par rapport au bâti (1,32), ainsi qu'avec un dispositif de désaccouplement qui est prévu entre le cristal et l'élément de tirage (4,35) et permet la séparation du cristal de l'élément de tirage (4,35), **CARACTERISE EN CE QUE**, le bâti (1,32) est formé par une plate-forme (8,38) portée par des appuis (37,37',37",37"'), sur la plate-forme (8,38) sensiblement rectangulaire maintenant la chambre de vide (5,33) une autre jambe (39,39',39") étant respectivement supportée sur trois de ses quatre coins et ces trois jambes (39,39',39") de même longueur s'étendant verticalement étant maintenues par un châssis (3,40) s'étendant verticalement, formant un triangle rectangle sur leurs extrémités supérieures, la surface projetée par ce châssis (3,40) sur la plate-forme circonscrivant sensiblement la moitié de la surface de la plate-forme (8,38), au moins l'une des jambes (39,39',39") portant une potence ou bras pivotant (21,29,41) sur lequel est fixé le sas (22,36) qui s'étend parallèlement aux jambes (39,39',39") jusqu'à sensiblement le couvercle (42) de la chambre de vide (5,33).

2. Dispositif selon la revendication 1, **CARACTERISE EN CE QUE**, trois appuis (37',37",37"') du bâti (32) sont prolongés au-delà de la plate-forme (38) et forment les trois jambes (39,39',39") du châssis supérieur (43).

3. Dispositif selon les revendications 1 et 2, **CARACTERISE EN CE QUE**, au moins l'une des jambes (39) forme l'arbre d'un palier pivotant vertical (44), sur lequel est fixé un bras (41) s'étendant horizontalement et qui, pour sa part porte le sas (36).

4. Dispositif selon les revendications 1 à 3, **CARACTERISE EN CE QUE**, sur la plate-forme (38) ou liaison transversale (8) est appuyée un système de levage/descente (8) par lequel un aimant annulaire (10) entourant la chambre de vide (5) est mobile verticalement.

5. Dispositif selon une ou plusieurs des revendications précédentes, **CARACTERISE EN CE QUE**, la chaudière ou la chambre de vide (5,33) sont soutenues par la plate-forme (38) ou la liaison transversale (8).
